# EUROPEAN PATENT SPECIFICATION

(11) **EP 1 279 841 B1**
(45) Date of publication and mention of the grant of the patent: **28.12.2005**
(21) Application number: 01204097.8
(22) Date of filing: 26.10.2001
(51) Int. Cl.: F16B 41/00, H01H 27/04, H01H 9/22, H01R 13/74, H02G 3/08, H02B 1/06, G08B 13/06

(54) **Wall-mounted electrical apparatus with anti-tamper device**
Gegen unerlaubte Benutzung gesichertes elektrisches Gerät zur Wandbefestigung
Appareillage électrique fixé à un mur pourvu d'un dispositif inviolable

(30) Priority: 24.07.2001 IT RM010441
(43) Date of publication of application: 29.01.2003
(73) Proprietor: BTICINO S.P.A., 20154 Milano (IT)
(72) Inventor: Fabrizi, Fabrizio, 24122 Bergamo (IT); De Cherubini, Sergio, 21100 Varese (IT)
(74) Representative: Siniscalco, Fabio

(56) References cited:
- EP-A- 0 744 805
- US-A- 4 150 371

## Description

The present invention relates to electrical apparatuses for wall-mounting comprising a box-shaped container and an anti-tamper device, according to the preamble of claim 1.

A typical apparatus of this type is a generally known meter installed in dwellings by the supplier of electrical energy for the purpose of measuring consumption and billing the relevant cost to the consumer.

In order to avoid unauthorized drawing-off of electrical energy and other interventions aimed at changing the state of the meter, there are various known measures, among which the most common firstly provides that the box containing the meter can be opened only by means of access from the base, that is to say, from the side intended to be fixed to the wall, and then that the removal of the box from the wall is possible only once a seal has been broken. A typical seal comprises a steel wire which extends through a hole in the head of a screw for fixing the box to the wall and through a ring which is formed on the box and which has its ends locked in a flattened lead seal, on which an identification symbol is stamped in the flattening stage. This known anti-tamper device requires relatively laborious operations to be installed and does not offer a sufficient guarantee of security since possible tampering can be concealed relatively simply by replacing the seal with an identical or very similar seal. Furthermore, tampering is detectable only by direct inspection of the meter and, therefore, when a possible unauthorized or fraudulent intervention, such as drawing-off of electrical energy, has already occurred and has caused damages to the supplier of electrical energy.

An objective of the present invention is to propose an electrical apparatus with an anti-tamper device which is simple and easy to install.
Another objective is to provide an electrical apparatus with an anti-tamper device such that tampering can be indicated as soon as it occurs.

Those objectives are met by producing the electrical apparatus according to the invention as defined in claim 1 in general and in successive dependent claims in respect of various particular embodiments.

The invention will be better understood from the following detailed description of one exemplary, nonlimiting embodiment thereof with reference to the appended drawings, in which:
- Figure 1 is a view of an electrical apparatus with parts separated according to the invention,
- Figure 2 is a view of an enlarged detail of the apparatus with parts separated in Figure 1,
- Figures 3 and 4 are a top view and a sectional view, respectively, of the detail in Figure 2 and
- Figures 5 and 6 show a portion of the electrical apparatus according to the invention before and after the activation of the anti-tamper device, respectively.

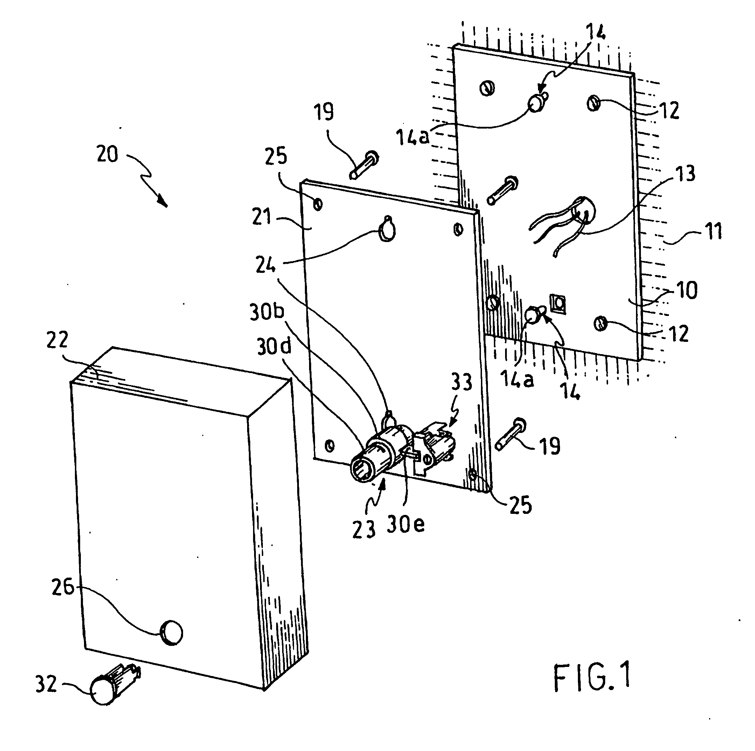

Figure 1 shows a backing plate 10 which can be, for example, of metal or of plastics material and which is fixed to a wall 11 by suitable fixing means, for example, screws 12. The plate 10 has an opening through which a number of electrical wires 13 emerging from the wall extend, two engaging elements, in this example two screws 14 having heads 14a partially projecting from the plate 10, and a nut 15 which is fixed to the plate, for example, by welding or in a recessed manner.

An electrical apparatus, for example, an electrical meter, is illustrated by its box-shaped container, denoted 20 as a whole. The container 20 is formed by a base member 21 and a cover member 22, both of insulating material, for example, a moulded plastics material. The electrical and/or electronic elements of the apparatus are mounted on the base 21, and are not illustrated so that the drawing is not unnecessarily complicated. An assembly 23, which constitutes the main part of the anti-tamper device, is also arranged on the base 21. Two shaped openings 24 allow the heads 14a of the screws 14 which project from the plate 10 to pass through and the box-shaped container 20 to be engaged on the plate 10. Four holes 25 allow the passage of the screws 19 for fixing the cover member 22 to the base member 21 by screwing the screws 19 into corresponding threaded holes, which are not visible in the Figure and which are arranged inside the cover member 22. The cover member 22 further has an opening 26 which allows the passage of a cylindrical member 30d of the assembly 23 of the anti-tamper device, but not of a coaxial cylindrical member 30b of greater diameter from the same assembly 23, and the introduction of a tool for fixing the container 20 to the plate 10, as will be explained in detail below.

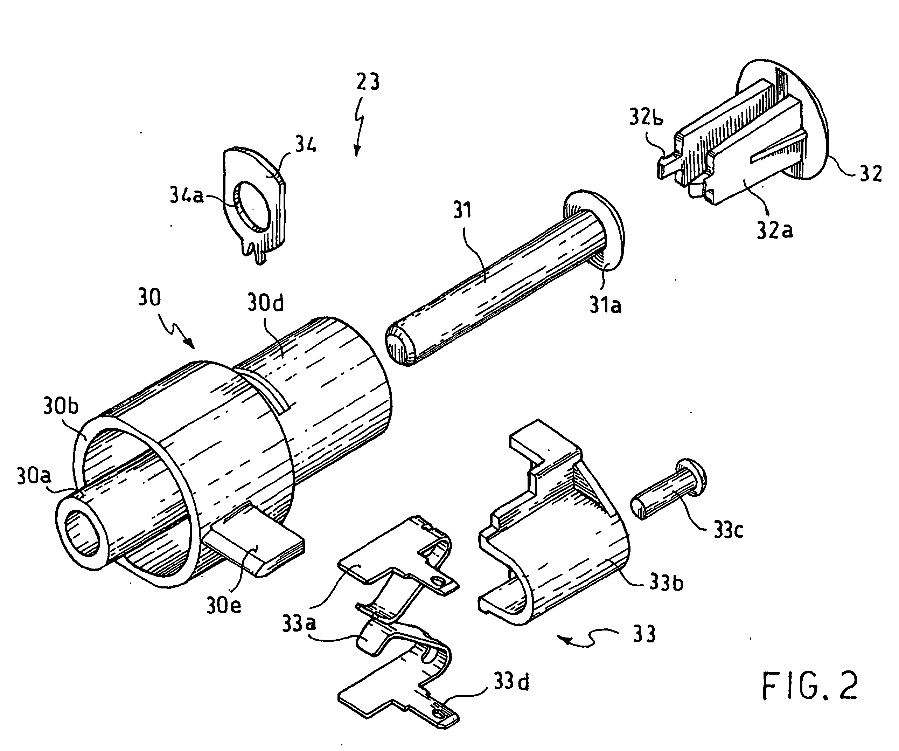

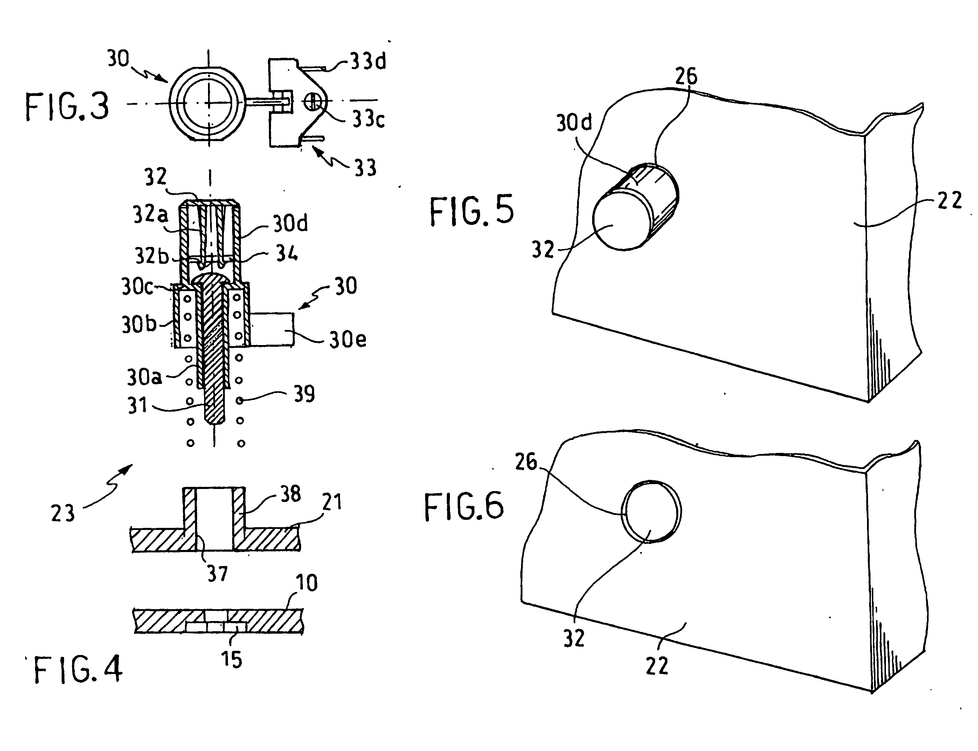

As shown in Figures 2 to 4, the anti-tamper device substantially comprises the assembly 23 and the nut 15 which is fixed firmly to the plate 10 and therefore to the wall 11. The assembly 23 comprises a hollow body 30 of an insulating material, for example, a plastics material, a screw 31, a closing element or plug 32 and a switch 33. The body 30 is formed by three hollow coaxial cylinders of different diameters which are connected to each other. The cylinder of smallest diameter 30a and the cylinder of largest diameter 30b are connected to each other by a radial connecting disc 30c (Figure 4), from which the cylinder of intermediate diameter 30d extends. The screw 31 can be inserted with play inside the cylinder 30a until it abuts the radial connecting disc 30c with the internal face of its head 31a. Once inserted, the screw 31 is held inside the cylinder 30a by a metal washer 34 having a central opening 34a, which is inserted transversely in the intermediate cylinder 30d and which is fixed thereto, for example, by means of bevelling. The cylinder 30b of largest diameter has a radial appendage in the form of a fin 30e. The switch 33 is formed by two contact elements of resilient sheet metal 33a and by a container and fixing element 33b of an insulating material. The element 33b is fixed to the base 21 by means of a screw 33c and holds the contact elements in such a manner that, in the absence of external stresses, they are in contact with each other. Each of the contact elements 33a has a terminal 33d for electrical connection to a circuit (not illustrated).

The base 21 has a circular opening 37 (Figure 4) of a slightly larger diameter than the external diameter of the cylindrical member 30a, surrounded by a cylindrical appendage 38 having an external diameter smaller than the internal diameter of the cylinder 30b in such a manner that a space is left between the two members.

A coil spring 39 (Figure 4) is inserted in the space and, in the absence of stresses, keeps the body 30 spaced from the base 21 and, in particular, the fin 30e in a position in which it does not interfere with the contact elements 33a of the switch 33.

Installation of the apparatus requires the following operations: positioning of the assembly 23 with the fin 30e arranged edgewise above the contact elements, installation of the cover member 22 on the base member 21 so that the cylindrical member 30d of intermediate diameter of the body 30 extends through the opening 26 and projects from the front plane of the cover member 22 (Figure 5), mutual fixing of the members 21 and 22 by means of the screws 19, engagement of the apparatus 20 on the plate 10 by insertion of the screws 14 in the openings 24 of the base 21, screwing of the screw 31 into the nut 15, which is joined to the plate 10, by means of a screwdriver extending inside the cylindrical member 30d and through the opening 34a of the retaining plate 34. The screwing causes the axial drive of the body 30 and therefore the movement in the same direction of the fin 30e, which is interposed between the contact elements 33a, thereby opening the contact of the switch 33. The contacts of the switch are connected to a circuit of a signalling device which, when the switch is open, is inactive but becomes operational when the switch is closed. Advantageously, the dimensions of the various members are selected so that, when the connecting disc 30c of the body 30 is in contact with the edge of the cylindrical appendage 38 of the base member 21, the cylindrical member 30d of intermediate diameter is located slightly below the front face of the cover member 22. At this point, the plug 32, which has two tongues 32a with teeth 32b at the ends, is inserted inside the cylindrical member 30d so that the teeth 32b engage with the washer 34, as is visible in Figure 4. Advantageously, as will be appreciated from Figures 2 and 4, the external portion of the plug 32 is shaped for connection to the external wall of the cylindrical member 30d to make it impossible to grip and therefore to remove the plug. Furthermore, the cylindrical member 30d remains substantially in alignment with the front face of the cover member 22, as shown in Figure 6, so that it is not possible to gain access to the screw 31 without breaking the plug 32 and thus revealing the attempt to tamper. Furthermore, if the attempt to tamper continues by way of unscrewing the screw 31, the body 30 moves axially under the effect of the thrust of the spring 39. As soon as the fin 36 releases the contact elements 33a, the switch closes, activating the signalling circuit. This circuit can operate an acoustic alarm and/or generate a signal which is transmitted to a control unit of the electrical energy supplier. As an alternative to the signalling circuit, or in conjunction therewith, there can be provided a device which irreversibly deactivates the supply of electrical energy.

As will be appreciated, the objectives of the invention are completely fulfilled. In particular, installation of the anti-tamper device is extremely simple because it is produced partly automatically by screwing the fixing screw of the apparatus to the plate which is fixed firmly to the wall and partly simply by snap-fitting of the plug 32. Furthermore, the efficacy of the device is increased by combining the signalling function with the function for indicating tampering.

## Claims

1. Electrical apparatus for wall-mounting comprising a box-shaped container (20) and an anti-tamper device (23, 15), the box-shaped container being formed by a base member (21) which has a side intended to be fixed to a wall (10, 11) and by a cover member (22) which can be fixed to the base member by removable fixing elements (19), which are accessible for removal solely from the side of the base member (21) that is intended to be fixed to the wall, **characterized in that** the anti-tamper device (23, 15) comprises fixing means (31, 15) for fixing the base member to the wall, which fixing means are accessible by means of a tool only through an opening (26) in the cover member, and **in that** closing means (32) are provided which cannot be removed when the anti-tamper device is activated and which are suitable for preventing the introduction of the tool.

2. Apparatus according to claim 1, wherein the anti-tamper device comprises indicating means (33, 30e) for indicating tampering.

3. Apparatus according to claim 2, wherein the indicating means comprise a controllable electrical switch (33) and activating means (30e) for activating the switch which are associated with said fixing means (31, 15) for fixing the anti-tamper device.

4. Apparatus according to claim 3, wherein the controllable electrical switch (33) comprises two contact elements (33a) which are fixed to the base member (21) and which are electrically isolated from each other and the activating means for activating the switch comprise a movable element (30) which is operated by the fixing means (31, 15).

5. Apparatus according to claim 4, wherein the two contact elements (30a) are acted on resiliently so that they are normally in contact with each other and wherein the movable element comprises a member of an insulating material (30e) which is inserted between the two contact elements, opening the switch when the fixing means are installed.

6. Apparatus according to any one of the preceding claims, wherein the fixing means comprise a screw (31) which extends through a hole (37) of the base member (21) and a nut (15) which is intended to be fixed firmly to the wall.

7. Apparatus according to claim 6 when dependent upon claim 5, wherein the movable element comprises a hollow body (30) through which the screw (31) extends and which has an internal abutment element, with which the head (31a) of the screw engages and wherein the member of insulating material comprises a fin (30e) which protrudes radially from the hollow body (30).

8. Apparatus according to claim 5, 6 or 7, wherein the anti-tamper device comprises resilient means (39) which act on the hollow body (30) in order to hold the member of an insulating material (30e) in a position in which the contact is closed when the fixing means are not operative.

9. Apparatus according to claim 7 or claim 8, wherein the anti-tamper device comprises a retaining element (34) which is fixed between the walls of the hollow body (30) to prevent the removal of the screw (31).

10. Apparatus according to claim 9, wherein the retaining element comprises a plate (34) having an opening (34a) through which a tool can extend to drive the screw.

11. Apparatus according to any one of claims 7 to 10, wherein the closing means comprise a plug (32) which closes the hollow body (30) at the end for access to the head of the screw (31).

12. Apparatus according to claim 11, wherein, when the cover member (22) is fixed to the base member (21) and the screw (31) is tightened into the nut (15) which is fixed firmly to the wall, the plug (32) does not protrude from the opening (26) of the cover member (22).

13. Apparatus according to any one of claims 6 to 12, comprising a backing plate (10) for fixing to the wall (11) and elements (14, 24) for engaging the base member (21) on the backing plate (10), and wherein the nut (15) which is intended to be fixed firmly to the wall is fixed firmly to the backing plate (10).

## Patentansprüche

1. Elektrische Vorrichtung zur Wandbefestigung, die einen kastenförmigen Behälter (20) und ein Anti-Eingriff-Bauelement (23, 15) aufweist, wobei der kastenförmige Behälter durch ein Basisbauglied (21), das eine Seite aufweist, die an einer Wand (10, 11) fixiert werden soll, und durch ein Abdeckungsbauglied (22) gebildet ist, das an dem Basisbauglied durch entfernbare Fixierelemente (19) fixiert werden kann, die für eine Entfernung nur von der Seite des Basisbauglieds (21), die an der Wand fixiert werden soll, zugreifbar sind, **dadurch gekennzeichnet, dass** das Anti-Eingriff-Bauelement (23, 15) eine Fixiereinrichtung (31, 15) zum Fixieren des Basisbauglieds an der Wand aufweist, wobei die Fixiereinrichtung mittels eines Werkzeugs lediglich durch eine Öffnung (26) in dem Abdeckungsbauglied zugreifbar ist, und **dadurch**, dass eine Verschlusseinrichtung (32) vorgesehen ist, die nicht entfernt werden kann, wenn das Anti-Eingriff-Bauelement aktiviert ist und die zum Verhindern der Einbringung des Werkzeugs geeignet ist.

2. Vorrichtung gemäß Anspruch 1, bei der das Anti-Eingriff-Bauelement eine Anzeigeeinrichtung (33, 30e) zum Anzeigen eines Eingreifens aufweist.

3. Vorrichtung gemäß Anspruch 2, bei dem die Anzeigeeinrichtung einen steuerbaren elektrischen Schalter (33) und eine Aktivierungseinrichtung (30e) zum Aktivieren des Schalters aufweist, die der Fixiereinrichtung (31, 15) zum Fixieren des Anti-Eingriff-Bauelements zugeordnet sind.

4. Vorrichtung gemäß Anspruch 3, bei der der steuerbare elektrische Schalter (33) zwei Kontaktelemente (33a) aufweist, die an dem Basisbauglied (21) fixiert sind und die elektrisch voneinander getrennt sind, und die Aktivierungseinrichtung zum Aktivieren des Schalters ein bewegbares Element (30) aufweist, das durch die Fixiereinrichtung (31, 15) betrieben wird.

5. Vorrichtung gemäß Anspruch 4, bei der elastisch auf die zwei Kontaktelemente (30a) gewirkt wird, so dass dieselben sich normalerweise in Kontakt miteinander befinden, und wobei das bewegbare Element ein Bauglied aus einem isolierenden Material (30e) aufweist, das zwischen die zwei Kontaktelemente eingefügt ist, wenn der Schalter geöffnet ist, wenn die Fixiereinrichtung installiert ist.

6. Vorrichtung gemäß einem der vorhergehenden Ansprüche, bei der die Fixiereinrichtung eine Schraube (31), die sich durch ein Loch (37) des Basisbauglieds (21) erstreckt, und eine Mutter (15) aufweist, die fest an der Wand fixiert sein soll.

7. Vorrichtung gemäß Anspruch 6, wenn abhängig von Anspruch 5, bei der das bewegbare Element einen Hohlkörper (30) aufweist, durch den sich die Schraube (31) erstreckt und der ein inneres Anschlagelement aufweist, mit dem der Kopf (31a) der Schraube in Eingriff gelangt, und wobei das Bauglied aus isolierendem Material eine Flosse (30e) aufweist, die radial von dem Hohlkörper (30) vorsteht.

8. Vorrichtung gemäß Anspruch 5, 6 oder 7, bei der das Anti-Eingriff-Bauelement eine elastische Einrichtung (39) aufweist, die auf den Hohlkörper (30) wirkt, um das Bauglied aus einem isolierenden Material (30e) in einer Stellung zu halten, in der der Kontakt geschlossen ist, wenn die Befestigungseinrichtung nicht wirksam ist.

9. Vorrichtung gemäß Anspruch 7 oder Anspruch 8, bei der das Anti-Eingriff-Bauelement ein Halteelement (34) aufweist, das zwischen den Wänden des Hohlkörpers (30) fixiert ist, um die Entfernung der Schraube (31) zu verhindern.

10. Vorrichtung gemäß Anspruch 9, bei der das Halteelement eine Platte (34) aufweist, die eine Öffnung (34a) aufweist, durch die ein Werkzeug sich erstrecken kann, um die Schraube zu treiben.

11. Vorrichtung gemäß einem der Ansprüche 7 bis 10, bei der die Verschlusseinrichtung einen Stöpsel (32) aufweist, der den Hohlkörper (30) bei dem Ende für einen Zugriff auf den Kopf der Schraube (31) verschließt.

12. Vorrichtung gemäß Anspruch 11, bei der, wenn das Abdeckungsbauglied (22) an dem Basisbauglied (21) fixiert ist und die Schraube (31) in die Mutter (15) festgezogen ist, die fest an der Wand fixiert ist, der Stöpsel (32) nicht von der Öffnung (26) des Abdeckungsbauglieds (22) vorsteht.

13. Vorrichtung gemäß einem der Ansprüche 6 bis 12, die eine Grundplatte (10) zum Fixieren an der Wand (11) und Elemente (14, 24) zum in Eingriff Bringen des Basisbauglieds (21) an der Grundplatte (10) aufweist, und wobei die Mutter (15), die fest an der Wand fixiert sein soll, fest an der Grundplatte (10) fixiert ist.

## Revendications

1. Appareil électrique destiné à un montage sur un mur comprenant un récipient en forme de boîte (20) et un dispositif inviolable (23, 15), le récipient en forme de boîte étant constitué d'un élément de base (21) qui comporte une face prévue être fixée à un mur (10, 11) et par un élément de couvercle (22) qui peut être fixé à l'élément de base par des éléments de fixation amovibles (19), lesquels sont accessibles pour un enlèvement uniquement à partir de la face de l'élément de base (21) et destiné à être fixé au mur, **caractérisé en ce que** le dispositif inviolable (23, 15) comprend un moyen de fixation (31, 15) destiné à fixer l'élément de base au mur, lequel moyen de fixation est accessible au moyen d'un outil uniquement au travers d'une ouverture (26) dans l'élément de couvercle, et **en ce qu'**un moyen de fermeture (32) est prévu, lequel ne peut pas être retiré lorsque le dispositif inviolable est activé et qui convient pour empêcher l'introduction de l'outil.

2. Appareil selon la revendication 1, dans lequel le dispositif inviolable comprend un moyen d'indication (33, 30e) destiné à indiquer un forçage.

3. Appareil selon la revendication 2, dans lequel le moyen d'indication comprend un commutateur électrique pouvant être commandé (33) et un moyen d'activation (30e) destiné à activer le commutateur qui est associé audit moyen de fixation (31, 15) pour fixer le dispositif inviolable.

4. Appareil selon la revendication 3, dans lequel le commutateur électrique pouvant être commandé (33) comprend deux éléments de contacts (33a) qui sont fixés à l'élément de base (21) et qui sont électriquement isolés l'un de l'autre et le moyen d'activation destiné à activer le commutateur comprend un élément mobile (33) qui est actionné par le moyen de fixation (31, 15).

5. Appareil selon la revendication 4, dans lequel les deux éléments de contacts (33a) sont actionnés de façon élastique de manière à ce qu'ils soient normalement en contact l'un avec l'autre et dans lequel l'élément mobile comprend un élément d'un matériau isolant (30e) qui est inséré entre les deux éléments de contacts, en ouvrant le commutateur lorsque le moyen de fixation est installé.

6. Appareil selon l'une quelconque des revendications précédentes, dans lequel le moyen de fixation comprend une vis (31) qui passe au travers d'un trou (37) de l'élément de base (21) et un écrou (15) qui est destiné à être fixé fermement au mur.

7. Appareil selon la revendication 6, lorsqu'elle dépend de la revendication 5, dans lequel l'élément mobile comprend un corps creux (30) au travers duquel passe la vis (31) et qui comporte un élément de butée interne, avec lequel la tête (31a) de la vis entre en contact et dans lequel l'élément de matériau isolant comprend une ailette (30e) qui dépasse radialement du corps creux (30).

8. Appareil selon la revendication 5, 6 ou 7, dans lequel le dispositif inviolable comprend un moyen élastique (39) qui agit sur le corps creux (30) de manière à maintenir l'élément de matériau isolant (30e) dans une position dans laquelle le contact est fermé lorsque le moyen de fixation n'est pas fonctionnel.

9. Appareil selon la revendication 7 ou la revendication 8, dans lequel le dispositif inviolable comprend un élément de retenue (34) qui est fixé entre les parois du corps creux (30) pour empêcher l'enlèvement de la vis (31).

10. Appareil selon la revendication 9, dans lequel l'élément de retenue comprend une plaque (34) comportant une ouverture (34a) au travers de laquelle peut passer un outil pour entraîner la vis.

11. Appareil selon l'une quelconque des revendications 7 à 10, dans lequel le moyen de fermeture comprend un bouchon (32) qui referme le corps creux (30) à l'extrémité destinée à l'accès à la tête de la vis (31).

12. Appareil selon la revendication 11, dans lequel, lorsque l'élément de couvercle (22) est fixé à l'élément de base (21) et que la vis (31) est serrée dans l'écrou (15) qui est fixé fermement au mur, le bouchon (32) ne dépasse pas de l'ouverture (26) de l'élément de couvercle (22).

13. Appareil selon l'une quelconque des revendications 6 à 12, comprenant une plaque support (10) destinée à la fixation au mur (11) et des éléments (14, 24) destiné à mettre en contact l'élément de base (21) sur la plaque support (10), et dans lequel l'écrou (15) qui est destiné à être fixé fermement au mur est fixé fermement à la plaque support (10).
